# EUROPÄISCHE PATENTSCHRIFT

(11) **EP 0 554 538 B1**
(45) Veröffentlichungstag und Bekanntmachung des Hinweises auf die Patenterteilung: **04.03.1998**
(21) Anmeldenummer: 92120535.7
(22) Anmeldetag: 02.12.1992
(51) Int. Cl.: F27B 9/36, C30B 25/10, F27B 9/06, F26B 3/30

(54) **Verfahren und Vorrichtung zum Erwärmen eines Materials**
Process and device for the heating of a material
Procédé et dispositif pour chauffer une matière

(30) Priorität: 01.02.1992 DE 4202944
(43) Veröffentlichungstag der Anmeldung: 11.08.1993
(73) Patentinhaber: Heraeus Noblelight GmbH, 63450 Hanau (DE)
(72) Erfinder: Schülke, Karl Albert, W-6451 Grosskrotzenburg (DE); Reul, Kurt, W-6466 Gründau 4 (DE); Sussmann, Ulrich, W-6463 Freigericht (DE)
(74) Vertreter: Staudt, Armin Walter

(56) Entgegenhaltungen:
- EP-A- 0 133 847
- WO-A-87/06636
- CH-A- 236 630
- GB-A- 2 181 459
- US-A- 4 882 852

## Beschreibung

Die Erfindung betrifft ein Verfahren zum Erwärmen eines Materials, das für Lichtwellenlängen im Wellenlängenbereich unterhalb 2500 nm eine relativ niedrige Absorption und im Wellenlängenbereich von oberhalb 2500 nm Bereiche mit relativ hoher Absorption aufweist, mittels mindestens eines Heizstrahlers, wobei die vom Heizstrahler ausgehende Primärstrahlung auf das zu erwärmende Material gerichtet und der darin nicht absorbierte Anteil als Reststrahlung zum Erwärmen des Materials nutzbar gemacht wird.

Weiterhin betrifft die Erfindung eine Vorrichtung zur Durchführung des Verfahrens, bei der zum Erwärmen eines Materials, das für Lichtwellenlängen im Wellenlängenbereich unterhalb 2500 nm eine relativ niedrige Absorption und im Wellenlängenbereich oberhalb 2500 nm Bereiche mit relativ hoher Absorption aufweist, mit mindestens einem Heizstrahler und mit mindestens einem, in Hauptabstrahlrichtung der vom Heizstrahler ausgehenden Strahlung gesehen, dem Heizstrahler nachgeordneten und von diesem beabstandeten, großflächig ausgebildeten Sekundärstrahler.

Ein derartiges Verfahren sowie eine Vorrichtung zu seiner Durchführung sind beispielsweise aus der US-PS 4,789,771 bekannt. Bei der bekannten Vorrichtung handelt es sich um einen aus oberer und unterer Kammer bestehenden Reaktor zur axial-symmetrischen Beschichtung von Substraten unter Wärmeeinwirkung. Als Wärmequellen sind innerhalb des Reaktors mehrere, parallel zueinander verlaufende Heizstrahler-Röhren angeordnet. Zur Erzielung einer gleichmäßigen Temperatur-Beaufschlagung des zu erwärmenden Substrates innerhalb des Reaktors sind die Reaktorinnenwände mit einer reflektierenden Beschichtung versehen. Die Deckenfläche und die Bodenfläche des Reaktors sind mit einer diffus reflektierenden Schicht, deren Reflektivität im Bereich um 0,95 liegt und die Seitenwände des Reaktors mit einer diffus- oder mit einer spiegelnd reflektierenden Schicht, wobei die Reflektivität der zuletzt genannten Schicht größer als 0,95 ist, beschichtet. Als beispielhafte Ausführungsform wird ein Reaktor beschrieben, bei dem in der oberen Kammer Heizstrahler vorgesehen sind, die das zu erwärmende Substrat erwärmen, wobei die vom Substrat nicht absorbierte Strahlung in der unteren Kammer reflektiert wird. Hierfür ist im Bodenbereich der unteren Kammer eine kreisförmige, diffus reflektierende Fläche, mit einer Reflektivität um 0,8, vorgesehen. Durch die Ausbildung des Reaktors mit reflektierenden Innenflächen wird erreicht, daß die von den Heizstrahlern ausgehende und zur Erwärmung des Substrates nicht genutzte Strahlung reflektiert und so zur weiteren Erwärmung des Substrates wieder nutzbar gemacht wird. Durch die diffuse Reflexion wird eine punktförmige oder eine andere bevorzugte Erhitzung von Bereichen innerhalb des Reaktors vermieden und die Strahlungsenergie im Innenraum des Reaktors gleichmäßig verteilt.

Aus der EP-A2 133 847 ist ein Durchlaufofen zum kontinuierlichen Erwärmen von Material bekannt, bei dem in einer Reflektoreinheit einer Vielzahl rohrförmiger, parallel zueinander verlaufender Heizstrahler ein plattenförmiger Reflektor, auf ihrer, der Hauptabstrahlrichtung abgewandten Seite zugeordnet ist. Der Reflektor, der aus keramischen Fasermaterial besteht, und eine Reflektivität von ca. 85% aufweist, wirkt dabei selbstreinigend, indem auf der erhitzten Reflektoroberfläche vorhandene Verunreinigungen verbrannt werden. Der bekannte Durchlaufofen weist zwei derartige, sich parallel gegenüberstehende Reflektoreinheiten auf, zwischen denen ein im rechten Winkel zu den Reflektoreinheiten verlaufendes Transportband mit dem zu erwärmenden Gut angeordnet ist.

Beim Erwärmen eines Materials, das im Wellenlängenbereich bis 2500 nm eine relativ niedrige Absorption aufweist, stellt sich das Problem der Anpassung der Strahlungs- Wellenlänge des verwendeten Heizstrahlers an das Absorptionsverhalten des zu erhitzenden Materials. Wird ein an die Absorption des zu erwärmenden Materials angepaßter Heizstrahler eingesetzt, dessen Strahlung eine Hauptwellenlänge im Bereich oberhalb von 2500 nm aufweist, dann absorbiert zwar das zu erwärmende Material die Strahlung und erwärmt sich dadurch, andererseits ist das Aufheiz- und Abkühlverhalten derartiger Strahler jedoch sehr langsam, so daß schnelle Temperaturwechsel damit nicht zu bewerkstelligen sind. So liegen beispielsweise bei den sogenannten "langwelligen Strahlern", deren Strahlung eine Hauptwellenlänge im Bereich oberhalb von 2800 nm aufweist, die Aufheiz- und Abkühlraten im Minutenbereich. Wegen des daraus resultierenden trägen Temperaturwechselverhaltens sind insbesondere beim Erwärmen temperaturempfindlicher Materialien, beispielsweise einer Folienbahn, in einem Durchlaufofen, sehr aufwendige Schutzmaßnahmen erforderlich, die es bei einem unerwarteten Stillstand des Transportbandes bzw. der Folienbahn ermöglichen, das temperaturempfindliche Material vor der weiteren Einwirkung des Heizstrahlers zu schützen. Bei dem Durchlaufofen gemäß der EP-A2 0133 847 ist zu diesem Zweck ein Schwenkmechanismus vorgesehen, der es erlaubt, die mit den Heizstrahlern bestückten Reflektoreinheiten des Durchlaufofens von dem zu erwärmenden Material zu entfernen.

Wird dagegen ein Strahler eingesetzt, der zwar ein schnelles Aufheizen und Abkühlen ermöglicht, beispielsweise ein sogenannter "kurzwelliger Strahler", dessen Strahlungs-Wellenlänge aber üblicherweise um 1200 nm und damit außerhalb des Wellenlängenbereiches liegt, in dem das zu erhitzenden Material eine relativ hohe Absorption aufweist, so erweist sich der Wirkungsgrad der vom Strahler abgegebenen zu der vom Material aufgenommenen und zur Erhitzung beitragenden Energie als relativ niedrig. Die verschlechterte Energieausnutzung erfordert wiederum längere Aufheizzeiten, so daß beispielsweise bei einem Durchlaufofen entweder die Durchlaufgeschwindigkeit des zu erwärmenden Materials durch den Ofen verlangsamt oder der Ofen entsprechend verlängert werden muß. Durch die Ausbildung des Durchlaufofens mit reflektierenden Innenflächen kann zwar die nicht absorbierte Strahlung mehrmals auf das zu erwärmende Material reflektiert und so erneut für das Aufheizen des Materials nutzbar gemacht werden; die Herstellung und die Wartung derartiger Kammern mit reflektierenden Innewänden ist zudem sehr aufwendig. Außerdem werden sämtliche Begrenzungswände unvermeidlich miterwärmt, so daß die gesamte Heizeinrichtung relativ träge auf Temperaturwechsel reagiert.

Der vorliegenden Erfindung liegt die Aufgabe zugrunde, das eingangs angegebene Verfahren so zu verbessern, daß bei einem guten Wirkungsgrad schnelle Temperaturwechsel ermöglicht werden und, ausgehend von der gattungsgemäßen Vorrichtung, eine einfache und kompakte Vorrichtung zur Durchführung des Verfahrens anzugeben.

Die Aufgabe wird hinsichtlich des Verfahrens dadurch gelöst, daß die Reststrahlung von einem, eine niedrige Wärmekapazität aufweisenden Strahlungswandler absorbiert und aus dem Strahlungswandler eine Sekundärstrahlung mit einem Wellenlängenbereich emittiert wird, der gegenüber dem der Primärstrahlung verschoben ist und der durch Anpassen der Temperatur des Strahlungswandlers so eingestellt wird, daß er mit einem Bereich relativ hoher Absorption des zu erwärmenden Materials überlappt. Durch die Absorption der Reststrahlung im Strahlungswandler nimmt dessen Energiegehalt zu. Dabei ist die Energieausbeute umso besser, je vollständiger die Absorption für die Rest- bzw. für die Primärstrahlung ist. Der Strahlungswandler erwärmt sich dadurch und emittiert seinerseits eine Sekundärstrahlung mit einem Wellenlängenbereich, der gegenüber demjenigen der Reststrahlung zu längeren Wellenlängen hin verschoben ist. Durch die Emission der Sekundärstrahlung nimmt der Energiegehalt des Strahlungswandlers ab. Im Gleichgewicht zwischen Absorption der Restrahlung und Emission der Sekundärstrahlung stellt sich auf der Oberfläche des Strahlungswandlers eine Gleichgewichtstemperatur ein, die den emittierten Wellenlängenbereich der Sekundärstrahlen maßgeblich bestimmt. Durch Verändern der Temperatur des Strahlungswandlers ist es möglich, den Wellenlängenbereich der Sekundärstrahlung so einzustellen, daß er mit einem Wellenlängenbereich relativ hoher Absorption des zu erhitzenden Materials überlappt. Hierdurch ist es somit möglich, den Energiegehalt der vom Heizstrahler emittierten Primärstrahlung, die von dem zu erwärmenden Material nicht oder nur wenig absorbiert wird, in eine Sekundärstrahlung umzuwandeln, deren Wellenlängenbereich an das Absorptionsverhalten des zu erwärmenden Materials angepaßt ist und dadurch im zu erwärmenden Material besser absorbiert wird als der Wellenlängenbereich der Primärstrahlung.

Die vom Strahlungswandler speicherbare Strahlungsenergie ist umso geringer, je niedriger die Wärmekapazität des Strahlungswandlers ist. Ein Strahlungswandler mit niedriger Wärmekapazität kühlt deshalb relativ schnell ab, sobald die Absorption der Reststrahlung, beispielweise durch ein Abschalten des Heizstrahlers, unterbrochen wird. Umgekehrt heizt er sich, sobald die Absorption einsetzt, schnell auf. Mit dem erfindungsgemäßen Verfahren sind daher schnelle Temperaturwechselvorgänge realisierbar. Je niedriger die Wärmekapazität des Strahlungswandlers ist, umso schneller kann bei ansonsten gleichen Bedingungen ein Temperaturwechsel erfolgen. Eine niedrige Wärmekapazität kann durch den Einsatz eines Materials mit niedriger spezifischer Wärmekapazität und/oder durch ein geringes Volumen des Strahlungswandlers erreicht werden.

Hinsichtlich eines guten Wirkungsgrades des Verfahrens hat es sich bewährt, die Temperatur des Strahlungswandlers zu regeln. Dabei hat es sich als vorteilhaft erwiesen, die Temperatur des Strahlungswandlers im Gleichgewicht zwischen der Energieaufnahme durch die Absorption der Reststrahlung im Strahlungswandler und der Energieabgabe durch die Emission der Wärmestrahlung, einzustellen. Besonders einfach gestaltet sich ein Verfahren, bei dem die Temperatur des Strahlungswandlers durch Verändern der Energie der Primärstrahlung eingestellt wird. Dabei kann die Temperatur des Strahlungswandlers gemessen und die gemessene Abweichung von der Solltemperatur als Regelparameter für die Leistung der Heizstrahlers verwendet werden. Dadurch ist es möglich den Wellenlängenbereich der Sekundärstrahlung konstant zu halten, was sich insbesondere beim Erwärmen von Material, das in einem nur schmalen Wellenlängenbereich oberhalb von 1500 nm ausreichend absorbiert, bewährt hat.

Es hat sich als vorteilhaft erwiesen, ein Material für den Strahlungswandler zu wählen, das für die Reststrahlung einen Absorptionskoeffizienten von mehr als 0,5, insbesondere zwischen 0,8 und 1 aufweist.
Für das erfindungsgemäße Verfahren hat es sich als besonders günstig erwiesen, als Primärstrahlung eine Strahlung auszuwählen, deren Hauptwellenlänge im Bereich zwischen 500 nm und 2800 nm, insbesondere eine kurzwellige Strahlung mit einer Hauptwellenlänge im Bereich zwichen 1000 nm und 2000 nm auszuwählen. Eine derartige Primärstrahlung zeichnet sich insbesondere durch eine sehr schnelle Aufheiz- und Abkühlcharakteristik aus, so daß damit schnelle Temperaturwechselvorgänge realisierbar sind.

Hinsichtlich der Vorrichtung wird die oben angegebene Aufgabe, ausgehend von der bekannten Vorrichtung, dadurch gelöst, daß der Sekundärstrahler als Strahlungswandler ausgebildet ist, in dem die Wellenlänge der vom Heizstrahler ausgehenden Strahlung absorbiert und von dem eine Sekundärstrahlung emittiert wird, deren Wellenlängenbereich mit einem Bereich relativ hoher Absorption des zu erwärmenden Materials überlappt.

Durch die Ausbildung des Sekundärstrahlers als Strahlungswandler, in dem die Wellenlänge der vom Heizstrahler ausgehenden Strahlung in einen Wellenlängenbereich verschoben wird, der mit einem Bereich relativ hoher Absorption des zu erhitzenden Materials überlappt, wird, und zwar im wesentlichen unabhängig von der Wellenlänge der vom Heizstrahler ausgehenden Strahlung, eine Umwandlung der vom Heizstrahler abgegebenen und nicht oder nur wenig absorbierbaren Strahlung in eine von dem zu erwärmenden Material absorbierbare Strahlung erreicht. Dadurch wird die vom Heizstrahler abgebene Strahlungsenergie besser ausgenutzt und der Wirkungsgrad erhöht. Der Wellenlängenbereich, der vom Strahlungswandler abgegebenen Sekundärstrahlung ist unabhängig vom Wellenlängenbereich der vom Heizstrahler abgegebenen Strahlung und hängt nur von der Temperatur der Oberfläche des Strahlungswandlers ab. Infolgedessen sind als Heizstrahler auch solche Heizstrahler einsetzbar, deren Strahlung einen Wellenlängenbereich aufweist, der vom zu erwärmenden Material nicht absorbiert wird. Der Heizstrahler muß daher nicht im Hinblick auf die Absorption des zu erwärmenden Materials ausgewählt werden, sondern kann hinsichtlich anderer Eigenschaften beispielsweise seines Aufheiz- oder Abkühlverhaltens optimiert werden. Dadurch, daß der Sekundärstrahler dem Heizstrahler in Hauptabstrahlrichtung nachgeordnet und von diesem beabstandet ist, wird erreicht, daß das zwischen dem Heizstrahler und dem Strahlungswandler befindlichen Material von der vom Heizstrahler ausgehenden Strahlung erwärmt wird, wobei jedoch, je nach Absorptionsgrad ein Teil der Strahlung durch das Material hindurch tritt und auf den Strahlungswandler trifft. Dieser wiederum heizt sich durch die Absorption der vom Heizstrahler ausgehenden Strahlung auf und emittiert eine Sekundärstrahlung, deren Wellenlängenbereich mit einem Bereich relativ hoher Absorption des zu erwärmenden Materials überlappt.

Besonders geeignet zur Ausbildung des Strahlungswandlers sind Materialien, deren Absorptionskoeffizient für die vom Strahler ausgehende Strahlung zwischen 0.5 und 1, insbesondere zwischen 0,8 und 1 liegt. Es haben sich hierbei insbesondere Strahlungswandler bewährt, deren Oberfläche schwarz eingefärbtes Aluminium oder miteinander vernetzte oder verfilzte keramische Fasern aufweist. Dabei handelt es sich um Materialien, die für sichtbare Strahlung oder für Strahlung aus dem infraroten Bereich undurchlässig sind und die eine gute Absorption für Strahlung aus diesen Wellenlängenbereichen aufweisen. Weiterhin zeichnen sich die Materialien durch eine hohe Temperaturwechselbeständigkeit aus, so daß die Haltbarkeit des Strahlungswandlers auch bei häufigen Temperaturwechseln gewährleistet wird.

Insbesondere im Hinblick auf schnelle Temperaturwechsel wird eine Vorrichtung bevorzugt, bei der der Strahlungswandler aus einem Material besteht, dessen spezifische Wärmekapazität niedrig ist.

Als besonders vorteilhaft haben sich Strahlungswandler mit einer unebenen Oberfläche, insbesondere solche mit einer geprägten Oberfläche erwiesen. Derartig ausgebildete Strahlungswandler-Oberflächen behindern insbesondere die Gasströmung entlang dieser Oberlächen, vermindern die Konvektions-Kühlung der Oberflächen und erhöhen damit den Wirkungsgrad des Strahlungswandlers.

Als besonders vorteilhaft haben sich Strahlungswandler erwiesen, die mit einer Temperaturmeßvorrichtung versehen sind. Dadurch ist es möglich, die Temperatur des Strahlungswandlers während des Betriebes der Vorrichtung ständig zu kontrollieren und gegebenenfalls bei einer Abweichung von der Soll-Temperatur zu korrigieren. Dies gewährleistet die Einhaltung der vom Strahlungswandler abzugebenden Strahlungs-Wellenlänge und kann eine Verschlechterung des Wirkungsgrades während des Betriebes der Vorrichtung verhindern. Insbesondere ist hierfür ein Strahlungswandler vorteilhaft, der mit einer Regelvorrichtung versehen ist. Die Regelvorrichtung kann eine Einrichtung zur kontinuierlichen Messung des Strahlungswandlers, beispielsweise ein Thermoelement oder ein Pyrometer umfassen, mit dem die Abweichung der Ist-Temperatur des Strahlungswandlers von der Soll-Temperatur ständig erfaßt und die als Regelparameter für die Energiezufuhr für den oder die Heizstrahler verwendet wird. Dadurch läßt sich die Temperatur und damit der vom Strahlungswandler als Sekundärstrahlung emittierte Wellenlängenbereich besonders genau einstellen und einhalten. Dies ist besonders vorteilhaft bei Materialien, die im betreffenden Wellenlängenbereich nur einen schmalen Absorptions-Peak aufweisen.

Es hat sich als günstig erwiesen, die Vorrichtung mit einem dünnwandigen Strahlungswandler auszubilden. Hierbei haben sich insbesondere Strahlungswandler mit einer Wandstärke zwischen 0,05 mm und 3 mm bewährt. Durch die dünnwandige Ausbildung wird eine möglichst geringe Wärmekapazität des Strahlungswandlers angestrebt, so daß von ihm nur eine geringe Wärmemenge speicherbar ist, beziehungsweise abgegeben werden kann. Dies ermöglicht ein schnelles Aufheizen bzw. ein rasches Abkühlen des Strahlungswandlers. Dabei gestaltet sich eine Vorrichtung mit einem plattenförmigen Strahlungswandler als besonders einfach.

Hinsichtlich eines möglichst großen Wirkungsgrades der Vorrichtung wird eine Ausbildung der Vorrichtung bevorzugt, bei der die Projektionsfläche des Strahlungswandlers entgegen der Hauptabstrahlrichtung der vom Heizstrahler ausgehenden Strahlung, auf eine senkrecht zur Hauptabstrahlrichtung verlaufende Ebene, die Projektionsfläche des Heizstrahlers auf diese Ebene umfaßt. Hierdurch wird erreicht, daß mindestens die in Hauptabstrahlrichtung vom Heizstrahler ausgehende Strahlung auf die Oberfläche des Strahlungswandlers trifft, sofern sie nicht vom zu erwärmenden Material absorbiert oder abgelenkt wird.

Weiterhin wird eine Ausführungsform der Vorrichtung bevorzugt, bei der der Heizstrahler ein kurzwelliger Strahler ist, dessen Strahlung eine Hauptwellenlänge im Bereich zwischen 1000 nm und 2000 nm aufweist. Kurzwellige Strahler weisen eine schnelle Aufheiz- und Abkühl-Charakteristik auf, so daß mit einer Ausbildung der Vorrichtung mit einem derartigen Strahler oder mit mehreren derartigen Strahlern schnelle Temperaturwechsel möglich sind. Mit kurzwelligen Strahlern ist zudem ein höherer Wirkungsgrad erreichbar, da sie relativ viel Strahlung und relativ wenig konvektive Wärme abgeben. Typische werte sind 90% Strahlungsenergie und nur 10% Erwärmung der umgebenden Atmosphäre.

Das erfindungsgemäße Verfahren und die Vorrichtung zur Durchführung des Verfahrens werden nachfolgend anhand einer Zeichnung beispielhaft erläutert.

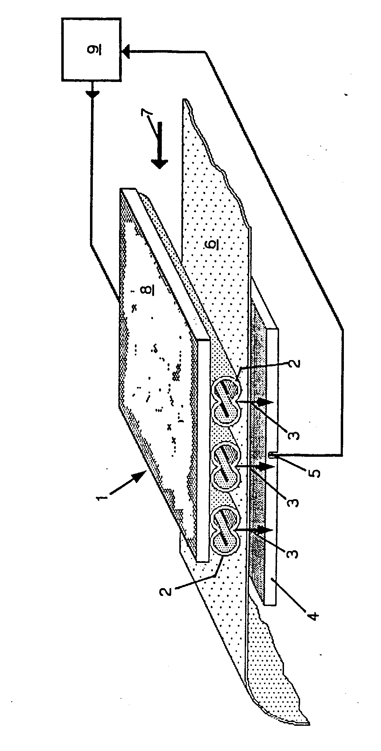

Die einzige Figur der Zeichnung zeigt in schematischer Darstellung eine Vorrichtung zum Aushärten einer Folienbahn.

In der Figur ist mit der Bezugsziffer 1 ein kurzwelliger Infrarotstrahler bezeichnet, der eine Strahlung mit einer Hauptwellenlänge um 1200 nm abgibt und der mehrere parallel zueinander verlaufende Strahlerröhren 2 aufweist. Die Strahlerröhren 2 sind als Zwillingsrohrstrahler ausgebildet und an einer als Reflektor dienenden Gehäusewand 8 des Infrarotstrahlers 1 befestigt. In Hauptabstrahlrichtung der Strahlerröhren 2, die mit dem Richtungspfeil 3 gekennzeichnet ist, ist dem Infrarotstrahler 1 ein Strahlungswandler 4 nachgeordnet, der aus miteinander verfilzten Keramikfasern besteht. Dabei umfaßt die Projektionsfläche des Strahlungswandlers 4 entgegen der Hauptabstrahlrichtung 3 auf eine senkrecht zur Hauptabstrahlrichtung 3 verlaufende Ebene, die Projektionsfläche des Infrarotstrahlers 1 auf diese Ebene. Die Temperatur des Strahlungswandlers 4, wird mittels eines Thermoelementes 5 erfaßt, das sich von der dem Infrarotstrahler 1 abgewandten Seite des Strahlungswandlers 4 in eine Bohrung bis nahe an die bestrahlte Oberflähe des Strahlungswandlers 4 erstreckt. Die vom Thermoelement 5 gemessene Temperatur wird in einer Regelvorrichtung 9 mit dem eingestellten Sollwert verglichen und die Abweichung als Regelparameter für die dem Infrarotstrahler 1 zuzuführende elektrische Energie verwendet. Zwischen dem Infrarotstrahler 1 und dem Strahlungswandler 4 befindet sich eine zu erwärmende Folienbahn 6, die in Richtung des Pfeiles 7 und parallel zur Oberfläche des Strahlungswandlers 4 verlaufend, zwischen dem Infrarotstrahler 1 und dem Strahlungswandler 4 hindurchgezogen wird.

Die von dem Infrarotstrahler 1 ausgehende Primärstrahlung mit einer Hauptwellenlänge um 1200 nm wird in der Folienbahn 6 nur zu einem geringen Teil absorbiert. Die in der Folienbahn 6 nicht absorbierte Reststrahlung trifft auf den Strahlungswandler 4, der für diese Strahlung einen Absorptions-Koeffizienten von ca. 0,95 aufweist und wird dort fast vollständig absorbiert. Dadurch heizt sich der Strahlungswandler 4 auf und emittiert seinerseits in Abhängigkeit von seiner Oberflächentemperatur eine Sekundärstrahlung, deren Wellenlängenbereich gegenüber dem der Primärstrahlung zu längeren Wellenlängen hin verschoben ist. Dabei wird die Temperatur des Strahlungswandlers 4 durch die Erwärmung aufgrund der vom Infrarotstrahler 1 ausgehenden Strahlung so eingestellt, daß die vom Strahlungswandler 4 emittierte Sekundärstrahlung einen Wellenlängenbereich aufweist, der von der Folienbahn 6 gut absorbiert wird. Da einerseits als Heizquelle ein kurzwelliger Infrarotstrahler 1 vorgesehen ist, andererseits der Strahlungswandler 4 dünnwandig ausgebildet ist und eine geringe spezifische Wärmekapazität aufweist, sind mit der erfindungsgemäßen Vorrichtung sehr schnelle Temperaturwechsel realisierbar.

Weitere Erläuterungen des erfindungsgemäßen Verfahrens und der erfindungsgemäßen Vorrichtung sowie einige daraus resultierende Vorzüge können den nachfolgend dargestellten Meßergebnissen, die Vergleiche zu den bekannten Verfahren und Vorrichtungen beeinhalten, entnommen werden. Die dabei verwendeten Bezugsziffern bezeichnen die gleichen Teile, wie sie oben und in der Figur anhand der entsprechenden Bezugsziffern erläutert sind oder dazu äquivalente Teile.

Es wurde ein kurzwelliger Infrarotstrahler 1 mit einer Leistung von 108 kW/m² eingesetzt, dessen Primärstrahlung eine Hauptwellenlänge von etwa 1100 nm aufweist. Der Infrarotstrahler 1 wurde in einem Abstand von 100 mm zu dem zu erwärmenden Objekt, in diesem Fall einer 1 mm dicken Glasplatte positioniert. Als Werkstoff für den Strahlungswandler 4 wurde ein handelsübliches, keramisches Fasermaterial (Handelsname "Kapyrock") gewählt, das eine rauhe Oberfläche aufweist und das die vom Infrarotstrahler 1 abgegebene Strahlung gut absorbiert. Die Messung der Aufheizraten ohne Strahlungswandler 4 und mit verschieden eingefärbten Strahlungswandlern 4 erbrachte das in Tabelle 1 dargestellte Ergebnis. In der Tabelle 1 bedeutet
A: Die Art des eingesetzten Strahlungswandlers
B: Die Temperatur des Strahlungswandlers 4 im Gleichgewicht zwischen absorbierter und emittierter Energie
C: Die Hauptwellenlänge der vom Strahlungswandler 4 emittierten Sekundärstrahlung
D: Die vom Strahlungswandler 4 im Gleichgewicht abgegebene Flächenleistung
E: Die Aufheizrate der Glasplatte bis zu einer Temperatur von 150° C

**Tabelle I**

| A | B | C | D | E |
|---|---|---|---|---|
| ohne Wandler | - | - | - | 18K/s |
| Kapyrock mit weißer Oberfläche | ca. 570°C | 3400 nm | 28kW/m² | 35K/s |
| Kapyrock mit schwarzer Oberfläche | ca. 660°C | 3050 nm | 44kW/m² | 54K/s |

In einem weiteren Vergleich wurde das zu erwärmende Objekt, nämlich wiederum eine 1 mm dicke Glasscheibe, zum einen beidseitig mit Heizstrahlern, und zwar mittelwelligen Infrarotstrahlern 1 mit einer Flächenleistung von 36 kW/m² und einer Hauptwellenlänge von 2600 nm, die mit einem Abstand von 100 mm zu der Glasplatte angeordnet waren, erwärmt. Zum Vergleich wurde die gleiche Glasplatte einseitig mit einem kurzwelligen Infrarotstrahler 1, der eine Flächenleistung von 72 kW/m² mit einer Hauptwellenlänge von 1600 nm aufweist und der ebenfalls in einem Abstand von 100 mm zu der Glasplatte angeordnet war, erwärmt, während auf der gegenüberliegenden Seite der Platte ein Strahlungswandler 4, nämlich eine Platte aus geschwärzter Mineralwolle, angeordnet war.

Tabelle II zeigt die aus dieser Versuchsanordnung resultierenden Ergebnisse im Vergleich. Dabei symbolisieren die Großbuchstaben A bis E die gleichen Parameter wie in der Tabelle I.

**Tabelle II**

| A | B | C | D | E |
|---|---|---|---|---|
| ohne Strahlungswandler | - | 2600 nm | 36 kW/m² (2x) | 27 K/s |
| mit Strahlungswandler | 590°C | 3700 nm | 72 kW | 31 K/s |

Die Ergebnisse der Tabelle I und der Tabelle II belegen, daß beim Erwärmen von Materialien, wie der im Vergleich verwendeten Glasplatte, die im Wellenlängenbereich bis 2500 nm eine relativ niedrige Absorption und im Wellenlängenbereich oberhalb 2500 nm Bereiche mit relativ hoher Absorption aufweisen, die Kombination eines kurzwelligen Infrarotstrahlers 1 mit einem Strahlungswandler 4 hinsichtlich der Aufheizgeschwindigkeit des zu erwärmenden Materials einer Kombination zweier mittelwelliger Infrarotstrahler 1 überlegen ist.

Weiterhin wurde die Abkühlgeschwindigkeit des bestrahlten Objektes in Verbindung mit einer erfindungsgemäßen Vorrichtung mit einem Strahlungswandler 4 gemessen. Hierbei wurde als Heizstrahler ein kurzwelliger Infrarotstrahler 1 mit einer Flächenleistung von 108 kW/m² in 100 mm Abstand zu dem Objekt angeordnet. Auf der gegenüberliegenden Seite des zu erwärmenden Objektes, einer 1 mm starken Glasplatte, in einem Abstand von 100 mm wurde der Strahlungswandler 4 angeordnet. Die Glasplatte wurde mit dieser Anordnung auf eine Temperatur von 250°C erwärmt und daraufhin der Infrarotstrahler 1 abgeschaltet. Es zeigte sich, daß die anfängliche Abkühlgeschwindigkeit der Glasplatte bei dieser Anordnung 6,7 K/sek betrug. Dies zeigt, daß mit dem erfindungsgemäßen Verfahren sowie der Vorrichtung zur Durchführung des Verfahrens auf einfache Weise sehr hohe Abkühlraten zu erzielen sind.

## Patentansprüche

1. Verfahren zum Erwärmen eines Materials, das für Lichtwellenlängen im Wellenlängenbereich unterhalb 2500 nm eine relativ niedrige Absorption und im Wellenlängenbereich von oberhalb 2500 nm Bereiche mit relativ hoher Absorption aufweist, mittels mindestens eines Heizstrahlers, wobei die vom Heizstrahler ausgehende Primärstrahlung auf das zu erwärmende Material gerichtet und der darin nicht absorbierte Anteil als Reststrahlung zum Erwärmen des Materials nutzbar gemacht wird, dadurch gekennzeichnet, daß die Reststrahlung von einem Strahlungswandler (4) absorbiert und aus dem Strahlungswandler (4) eine Sekundärstrahlung mit einem Wellenlängenbereich emittiert wird, der gegenüber dem der Primärstrahlung verschoben ist und der durch Anpassen der Temperatur des Strahlungswandlers (4) so eingestellt wird, daß er mit einem Bereich relativ hoher Absorption des zu erwärmenden Materials (6) überlappt.

2. Verfahren nach Anspruch 1, dadurch gekennzeichnet, daß die Temperatur des Strahlungswandlers (4) im Gleichgewicht zwischen der Energieaufnahme durch die Absorption der Primärstrahlung und die Energieabgabe durch die Emission der Sekundärstrahlung eingestellt wird.

3. Verfahren nach Anspruch 1 und 2, dadurch gekennzeichnet, daß die Temperatur des Strahlungswandlers (4) geregelt wird.

4. Verfahren nach Anspruch 3, dadurch gekennzeichnet, daß die Temperatur des Strahlungswandlers (4) durch Verändern der Strahlungsleistung der Primärstrahlung eingestellt wird.

5. Verfahren nach einem der Ansprüche 1 bis 4, dadurch gekennzeichnet, daß für den Strahlungswandler (4) ein Material gewählt wird, das für die Reststrahlung einen Absorptionskoeffizienten zwischen 0,5 und 1 aufweist.

6. Verfahren nach Anspruch 5, dadurch gekennzeichnet, daß für den Strahlungswandler (4) ein Material gewählt wird, das für die Reststrahlung einen Absorptionskoeffizienten zwischen 0,8 und 1 aufweist.

7. Verfahren nach einem der Ansprüche 1 bis 6, dadurch gekennzeichnet, daß ein Strahlungswandler (4) mit einer niedrigen Wärmekapazität eingesetzt wird.

8. Verfahren nach einem der Ansprüche 1 bis 7, dadurch gekennzeichnet, daß als Primärstrahlung eine Stahlung mit einer Hauptwellenlänge im Bereich zwischen 500 nm und 2800 nm gewählt wird.

9. Verfahren nach Anspruch 8, dadurch gekennzeichnet, daß als Primärstrahlung kurzwellige Strahlung mit einer Hauptwellenlänge im Bereich zwischen 1000 nm und 2000 nm gewählt wird.

10. Vorrichtung zum Erwärmen eines Materials, das für Lichtwellenlängen im Wellenlängenbereich unterhalb 2500 nm eine relativ niedrige Absorption und im Wellenlängenbereich oberhalb 2500 nm Bereiche mit relativ hoher Absorption aufweist, mit mindestens einem Heizstrahler und mit mindestens einem, in Hauptabstrahlrichtung der vom Heizstrahler ausgehenden Strahlung gesehen, dem Heizstrahler nachgeordneten und von diesem beabstandeten, großflächig ausgebildeten Sekundärstrahler, dadurch gekennzeichnet, daß der Sekundärstrahler als Strahlungswandler (4) ausgebildet ist, in dem die Wellenlänge der vom Heizstrahler (1) ausgehenden Strahlung absorbiert, und von dem eine Sekundärstrahlung emittiert wird, deren Wellenlängenbereich mit einem Bereich relativ hoher Absorption des zu erwärmenden Materials (6) überlappt.

11. Vorrichtung nach Anspruch 10, dadurch gekennzeichnet, daß der Strahlungswandler (4) aus einem Material besteht, dessen Absorptionskoeffizient für die vom Heizstrahler (1) ausgehende Strahlung zwischen 0,5 und 1 beträgt.

12. Vorrichtung nach Anspruch 10 oder 11, dadurch gekennzeichnet, daß der Strahlungswandler (4) ein Material mit niedriger spezifischer Wärmekapazität enthält.

13. Vorrichtung nach einem der Ansprüche 10 bis 12, dadurch gekennzeichnet, daß der Strahlungswandler (4) eine Oberfläche mit schwarz eingefärbtem Aluminium aufweist.

14. Vorrichtung nach einem der Ansprüche 10 bis 12, dadurch gekennzeichnet, daß der Strahlungswandler (4) eine Oberfläche aufweist, die keramische Fasern enthält.

15. Vorrichtung nach Anspruch 14, dadurch gekennzeichnet, daß die keramischen Fasern miteinander vernetzt oder verfilzt sind.

16. Vorrichtung nach einem der Ansprüche 10 bis 15, dadurch gekennzeichnet, daß der Strahlungswandler (4) mit einer unebenen Oberfläche, insbesondere mit einer geprägten Oberfläche ausgebildet ist.

17. Vorrichtung nach einem der Ansprüche 10 bis 16, dadurch gekennzeichnet, daß der Strahlungswandler (4) mit einer Temperaturmeßvorrichtung (5) versehen ist.

18. Vorrichtung nach Anspruch 17, dadurch gekennzeichnet, daß der Strahlungswandler (4) mit einer Regelvorrichtung (5;9) verbunden ist.

19. Vorrichtung nach einem der Ansprüche 10 bis 18, dadurch gekennzeichnet, daß der Strahlungswandler (4) dünnwandig, insbesondere mit einer Wandstärke zwischen 0,05 mm und 3 mm, ausgebildet ist.

20. Vorrichtung nach einem der Ansprüche 10 bis 19, dadurch gekennzeichnet, daß der Strahlungswandler (4) plattenförmig ausgebildet ist.

21. Vorrichtung nach einem der Ansprüche 10 bis 20, dadurch gekennzeichnet, daß die Projektionsfläche des Strahlungswandlers (4) entgegen der Hauptabstrahlrichtung (3) der vom Heizstrahler (1) ausgehenden Strahlung, auf eine senkrecht zur Hauptabstrahlrichtung (3) verlaufende Ebene, die Projektionsfläche des Heizstrahlers (1) auf diese Ebene umfaßt.

22. Vorrichtung nach einem der Ansprüche 10 bis 21, dadurch gekennzeichnet, daß der Heizstrahler (1) ein kurzwelliger Strahler ist, dessen Strahlung eine Hauptwellenlänge im Bereich zwischen 500 nm und 2800 nm aufweist.

## Claims

1. A method for the heating of a material, which has a relatively low absorption for light wavelengths in the wavelength range below 2500 nm and has regions with relatively high absorption in the wavelength range of above 2500 nm, by means of at least one heat emitter, the primary radiation originating from the heat emitter being directed onto the material which is to be heated and the non-absorbed part therein being made useful as residual radiation for heating the material, characterised in that the residual radiation is absorbed by a radiation converter (4) and from the radiation converter (4) a secondary radiation is emitted with a wavelength range which is shifted with respect to that of the primary radiation and which, through adaptation of the temperature of the radiation converter (4) is set so that it overlaps with a region of relatively high absorption of the material (6) which is to be heated.

2. The method according to Claim 1, characterised in that the temperature of the radiation converter (4) is set in balance between the energy intake through the absorption of the primary radiation and the energy release through the emission of the secondary radiation.

3. The method according to Claim 1 and 2, characterised in that the temperature of the radiation converter (4) is regulated.

4. The method according to Claim 3, characterised in that the temperature of the radiation converter (4) is adjusted by altering the radiated power of the primary radiation.

5. The method according to one of Claims 1 to 4, characterised in that for the radiation converter (4) a material is selected which for the residual radiation has an absorption coefficient between 0.5 and 1.

6. The method according to Claim 5, characterised in that for the radiation converter (4) a material is selected which for the residual radiation has an absorption coefficient between 0.8 and 1.

7. The method according to one of Claims 1 to 6, characterised in that a radiation converter (4) with a low thermal capacity is used.

8. The method according to one of Claims 1 to 7, characterised in that as primary radiation a radiation with a main wavelength in the range between 500 nm and 2800 nm is selected.

9. The method according to Claim 8, characterised in that as primary radiation short-wave radiation with a main wavelength in the range between 1000 nm and 2000 nm is selected.

10. A device for the heating of a material which has a relatively low absorption for light wavelengths in the wavelength range below 2500 nm and has regions with relatively high absorption in the wavelength range above 2500 nm, with at least one heat emitter and with at least one secondary emitter, constructed having a large area, arranged after the heat emitter and at a distance therefrom, viewed in the main emission direction of the radiation originating from the heat emitter, characterised in that the secondary emitter is constructed as a radiation converter (4) in which the wavelength of the radiation originating from the heat emitter (1) is absorbed and from which a secondary radiation is emitted, the wavelength range of which overlaps with a region of relatively high absorption of the material (6) which is to be heated.

11. The device according to Claim 10, characterised in that the radiation converter (4) consists of a material, the absorption coefficient of which for the radiation originating from the heat emitter (1) amounts to between 0.5 and 1.

12. The device according to Claim 10 or 11, characterised in that the radiation converter (4) contains a material with low specific thermal capacity.

13. The device according to one of Claims 10 to 12, characterised in that the radiation converter (4) has a surface with black-coloured aluminium.

14. The device according to one of Claims 10 to 12, characterised in that the radiation converter (4) has a surface which contains ceramic fibres.

15. The device according to Claim 14, characterised in that the ceramic fibres are cross-linked or interlocked with each other.

16. The device according to one of Claims 10 to 15, characterised in that the radiation converter (4) is constructed with an uneven surface, in particular with an embossed surface.

17. The device according to one of Claims 10 to 16, characterised in that the radiation converter (4) is provided with a temperature measurement device (5).

18. The device according to Claim 17, characterised in that the radiation converter (4) is connected with a regulating device (5;9).

19. The device according to one of Claims 10 to 18, characterised in that the radiation converter (4) is constructed having thin walls, in particular with a wall thickness between 0.05 mm and 3 mm.

20. The device according to one of Claims 10 to 19, characterised in that the radiation converter (4) is constructed in a plate shape.

21. The device according to one of Claims 10 to 20, characterised in that the projection area of the radiation converter (4), contrary to the main emission direction (3) of the radiation originating from the heat emitter (1), onto a plane running perpendicularly to the main emission direction (3), comprises the projection area of the heat emitter (1) onto this plane.

22. The device according to one of Claims 10 to 21, characterised in that the heat emitter (1) is a short-wave emitter, the radiation of which has a main wavelength in the range between 500 nm and 2800 nm.

## Revendications

1. Procédé pour chauffer un matériau qui présente une absorption relativement basse pour des longueurs d'ondes lumineuses sur la plage des longueurs d'ondes inférieures à 2500 nm et une absorption relativement élevée sur la plage de longueurs d'ondes supérieures à 2500 nm, au moyen d'au moins un émetteur de rayonnement thermique, dans lequel le rayonnement primaire sortant de l'émetteur de rayonnement thermique est dirigé sur le matériau à chauffer et la portion qui n'y est pas absorbée est rendue utilisable sous forme de rayonnement résiduel pour chauffer le matériau, caractérisé par le fait que le rayonnement résiduel est absorbé par un convertisseur de rayonnement (4) et que le convertisseur de rayonnement (4) émet un rayonnement secondaire sur une plage de longueurs d'ondes qui est décalée par rapport à celle du rayonnement primaire et qu'en adaptant la température du convertisseur de rayonnement (4), on règle cette plage de façon qu'elle recouvre partiellement une plage d'absorption relativement élevée du matériau (6) à réchauffer.

2. Procédé selon la revendication 1, caractérisé par le fait que l'on règle la température du convertisseur de rayonnement (4) en équilibre entre la réception d'énergie par l'absorption du rayonnement primaire et l'émission d'énergie par l'émission du rayonnement secondaire.

3. Procédé selon les revendications 1 et 2, caractérisé par le fait que l'on règle la température du convertisseur de rayonnement (4).

4. Procédé selon la revendication 3, caractérisé par le fait que l'on intervient sur la température du convertisseur de rayonnement (4) en modifiant la puissance du rayonnement primaire.

5. Procédé selon l'une des revendications 1 à 4, caractérisé par le fait que pour le convertisseur de rayonnement (4) on choisit un matériau qui présente pour le rayonnement résiduel un coefficient d'absorption valant entre 0,5 et 1.

6. Procédé selon la revendication 5, caractérisé par le fait que pour le convertisseur de rayonnement (4) on choisit un matériau qui présente, pour le rayonnement résiduel, un coefficient d'absorption valant entre 0,8 et 1.

7. Procédé selon l'une des revendications 1 à 6, caractérisé par le fait que l'on emploie un convertisseur de rayonnement (4) à faible capacité calorifique.

8. Procédé selon l'une des revendications 1 à 7, caractérisé par le fait que comme rayonnement primaire on choisit un rayonnement d'une longueur d'onde principale sur la plage de 500 nm à 2800 nm.

9. Procédé selon la revendication 8, caractérisé par le fait que comme rayonnement primaire on choisit un rayonnement à onde courte d'une longueur d'onde principale sur la plage de 1000 nm à 2000 nm.

10. Dispositif pour chauffer un matériau qui présente une absorption relativement faible sur la plage des longueurs d'ondes inférieures à 2500 nm et une absorption relativement élevée sur la plage des longueurs d'ondes supérieures à 2500 nm, comportant au moins un émetteur de rayonnement thermique et au moins un émetteur de rayonnement secondaire à grande surface, disposé après l'émetteur de rayonnement thermique, vu depuis le rayonnement émis par l'émetteur de rayonnement thermique, et à une certaine distance de celui-ci, caractérisé par le fait que l'émetteur de rayonnement secondaire est conçu sous forme d'un convertisseur de rayonnement (4) dans lequel la longueur d'onde du rayonnement émis par l'émetteur de rayonnement thermique (1) est absorbée et qui émet un rayonnement secondaire dont la plage de longueurs d'ondes recouvre partiellement une plage d'absorption relativement élevée du matériau à chauffer (6).

11. Dispositif selon la revendication 10, caractérisé par le fait que le convertisseur de rayonnement (4) est constitué d'un matériau dont le coefficient d'absorption pour le rayonnement émis par l'émetteur de rayonnement thermique (1) vaut entre 0,5 et 1.

12. Dispositif selon la revendication 10 ou 11, caractérisé par le fait que le convertisseur de rayonnement (4) contient un matériau à faible capacité calorifique spécifique.

13. Dispositif selon l'une des revendications 10 à 12, caractérisé par le fait que le convertisseur de rayonnement (4) présente une surface en aluminium coloré en noir.

14. Dispositif selon l'une des revendications 10 à 12, caractérisé par le fait que le convertisseur de rayonnement (4) présente une surface qui contient des fibres céramiques.

15. Dispositif selon la revendication 14, caractérisé par le fait que les fibres céramiques sont réticulées ou feutrées les unes avec les autres.

16. Dispositif selon l'une des revendications 10 à 12, caractérisé par le fait que le convertisseur de rayonnement (4) est conçu avec une surface non plane, en particulier avec une surface matricée.

17. Dispositif selon l'une des revendications 10 à 16, caractérisé par le fait que le convertisseur de rayonnement (4) est muni d'un dispositif de mesure de la température (5).

18. Dispositif selon la revendications 17, caractérisé par le fait que le convertisseur de rayonnement (4) est relié à un dispositif de régulation (5; 9).

19. Dispositif selon l'une des revendications 10 à 18, caractérisé par le fait que le convertisseur de rayonnement (4) est conçu à paroi mince, en particulier avec une épaisseur de paroi valant entre 0,05 mm et 3 mm.

20. Dispositif selon l'une des revendications 10 à 19, caractérisé par le fait que le convertisseur de rayonnement (4) est conçu en forme de panneau.

21. Dispositif selon l'une des revendications 10 à 20, caractérisé par le fait que la surface du convertisseur de rayonnement (4), projetée, en sens inverse à la direction (3) du rayonnement principal émis par l'émetteur de rayonnement thermique (1), sur un plan perpendiculaire à la direction (3) du rayonnement principal circonscrit la surface de l'émetteur de rayonnement thermique (1) projetée sur ce plan.

22. Dispositif selon l'une des revendications 10 à 21, caractérisé par le fait que l'émetteur de rayonnement thermique (1) est un émetteur de rayonnement à onde courte dont le rayonnement présente une longueur d'onde principale sur la plage valant entre 500 nm et 2800 nm.
